Europäisches Patentamt

European Patent Office

Office européen des brevets

(19)

(11) Publication number: **0 115 187 B1**

(12) **EUROPEAN PATENT SPECIFICATION**

(45) Date of publication of patent specification: **20.02.91**  (51) Int. Cl.⁵: **G11C 8/00**

(21) Application number: **83307901.5**

(22) Date of filing: **22.12.83**

(54) Semiconductor memory device with decoder means.

(30) Priority: **29.12.82 JP 233906/82**

(43) Date of publication of application:
**08.08.84 Bulletin 84/32**

(45) Publication of the grant of the patent:
**20.02.91 Bulletin 91/08**

(84) Designated Contracting States:
**DE FR GB**

(56) References cited:
**EP-A- 0 024 894**
**US-A- 3 599 182**
**US-A- 3 688 280**
**US-A- 4 027 285**

**C.RINT:"Handbuch für Hochfrequenz-und
Elektrotechniker", Volum 3, 1979,
München/Heidelberg, Verl.Hüthig und
Pflaum, 1979**

(73) Proprietor: **FUJITSU LIMITED**
**1015, Kamikodanaka Nakahara-ku**
**Kawasaki-shi Kanagawa 211(JP)**

(72) Inventor: **Matsuzaki, Yasuro**
**1522, Sekido**
**Tama-shi Tokyo 206(JP)**
Inventor: **Fukushima, Toshitaka**
**1604-442, Shiomidai Isogo-ku**
**Yokohama-shi Kanagawa 235(JP)**
Inventor: **Ueno, Kouji**
**1360, Shukugawara Tama-ku**
**Kawasaki-shi Kanagawa 214(JP)**

(74) Representative: **Skone James, Robert Edmund
et al**
**GILL JENNINGS & EVERY 53-64 Chancery
Lane**
**London WC2A 1HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a semiconductor memory device, more particularly to a semiconductor memory device of reduced power consumption.

As is well known, a semiconductor memory device includes a plurality of memory cells arranged in a matrix form, a decoder circuit, a multiplexer circuit, a group of word lines connected to the decoder circuit to activate one of the rows of the matrix, and a group of bit lines connected to the multiplexer circuit to activate one of the columns of the matrix. When a memory system requires a memory capacity over that of a single memory device, two or more memory devices are provided in parallel.

The conventional technique for reducing power consumption of a memory system is to provide a switching circuit outside each memory device. The switching circuit is connected to the power supply terminal of the memory device. Using the switching circuit, it is possible to supply power only to the memory device which is to be accessed, i.e., power is not supplied to other memory devices.

This method, however, is disadvantageous in that the switching time for the switching circuit outside of the memory device increases the memory access time.

Also, this method is rapidly losing its effectiveness in the face of the recent increases in memory capacities of individual memory devices, now 64K bits or 128K bits, and the resultant increases in the size of the memory devices. It is no longer sufficient to reduce the power consumption by switching off power to non-accessed memory circuits.

EP-A-0024894 describes a semiconductor memory device comprising a plurality of rows of memory cells; and decoder means for selecting one row of the matrix in response to a corresponding one of a plurality of address signals, the decoder means comprising a first stage decoder having a plurality of first stage decoding elements, each of the first stage decoding elements being connected to a plurality of second stage decoding elements of a second stage decoder, wherein each of the first stage decoding elements receives part of the plurality of address signals, whereby one of the second stage decoding elements causes a row of the matrix to be selected, and wherein each of the second stage decoding elements includes at least one second gate circuit receiving said remaining part of the plurality of address signals, the output of the second gate circuit being connected to the output of the respective first stage decoding element, and at least one switching element having a trigger terminal connected to the output of the respective first stage decoding element, the output of the switching element selecting one of the rows of memory cells when the output of the corresponding first stage decoding element is high and the output of the second gate circuit is high.

US-A-4027285 discloses the use of Schottky barrier diodes in decoder AND gates.

This device suffers from problems of high power consumption and low speed operation.

In accordance with one aspect of the present invention, a semiconductor memory device comprises a plurality of rows of memory cells; and decoder means for selecting one row of the matrix in response to a corresponding one of a plurality of address signals, the decoder means comprising a first stage decoder having a plurality of first stage decoding elements, each of the first stage decoding elements being connected to a plurality of second stage decoding elements of a second stage decoder, wherein each of the first stage decoding elements receives part of the plurality of address signals, whereby one of the second stage decoding elements causes a row of the matrix to be selected, and wherein each of the second stage decoding elements includes at least one second gate circuit receiving said remaining part of the plurality of address signals, the output of the second gate circuit being connected to the output of the respective first stage decoding element, and at least one switching element having a trigger terminal connected to the output of the respective first stage decoding element, the output of the switching element selecting one of the rows of memory cells when the output of the corresponding first stage decoding element is high and the output of the second gate circuit is high, and is characterised in that the second gate circuit comprises a plurality of diodes arranged to form an AND gate and in that each second gate circuit includes an extra gate portion comprising a number of diodes arranged to form an AND gate and for receiving the part of the address signals fed to the corresponding first stage decoding elements.

In accordance with a second aspect of the present invention, a semiconductor memory device comprises a plurality of rows of memory cells; and decoder means for selecting one row of the matrix in response to a corresponding one of a plurality of address signals, the decoder means comprising a first stage decoder having a plurality of first stage decoding elements, each of the first stage decoding elements being connected to a plurality of second stage decoding elements of a second stage decoder, wherein each of the first stage decoding elements receives part of the plurality of address signals, whereby one of the second stage decoding elements causes a row of the matrix to be selected, and wherein each of the second stage decoding elements includes at least one second gate circuit receiving said remaining part of the plurality of address signals, the output of the second gate circuit being connected to the output of the respective first stage decoding element, and at least one switching element having a trigger terminal connected to the output of the respective first stage decoding element, the output of the switching element selecting one of the rows of memory cells when the output of the corresponding first stage decoding element is high and the output of the second gate circuit is high and is characterised in that the second gate circuit comprises a multi-emitter transistor forming an AND gate and to respective emitters of which are fed said remaining part of the plurality of address signals and the part of the address signals fed to the corresponding first stage decoding elements.

By applying to the second gate circuit or multi-emitter transistor the part of the address signal which is fed to the corresponding first stage decoding element a significant increase in the speed of operation of the device is achieved. The device also has a reduced power consumption over conventional devices.

Some examples of semiconductor memory devices in accordance with the present invention will now be described and contrasted with a prior art device with reference to the accompanying drawings, in which:

Figure 1 is a circuit diagram of a prior art memory system including two memory devices arranged in parallel and two external switching circuits connected to the memory devices;

Figure 2 is a circuit diagram of the external switching circuits and the decoder circuits in the memory devices shown in Figure 1;

Figure 3 is a block diagram of a memory device showing those elements common to both the invention and the prior art;

Figure 4 is a circuit diagram of a circuit for converting an external address signal to an internal address signal connected to the decoder circuit of the device shown in Figure 3;

Figure 5 is a curve showing the general relationship between the number of first-stage decoding gates and the power consumption of the decoder circuit in semiconductor memory devices;

Figure 6 shows an embodiment of the decoder circuit shown in Figure 3;

Figure 7 shows a first embodiment of the decoder circuit shown in Figure 3 in accordance with the invention;

Figure 8 shows still another embodiment of the decoder circuit shown in Figure 3 in accordance with the invention;

Figure 9 shows another embodiment of the decoder circuit shown in Figure 3,some features of which are applicable to the Figure 7 embodiment; and,

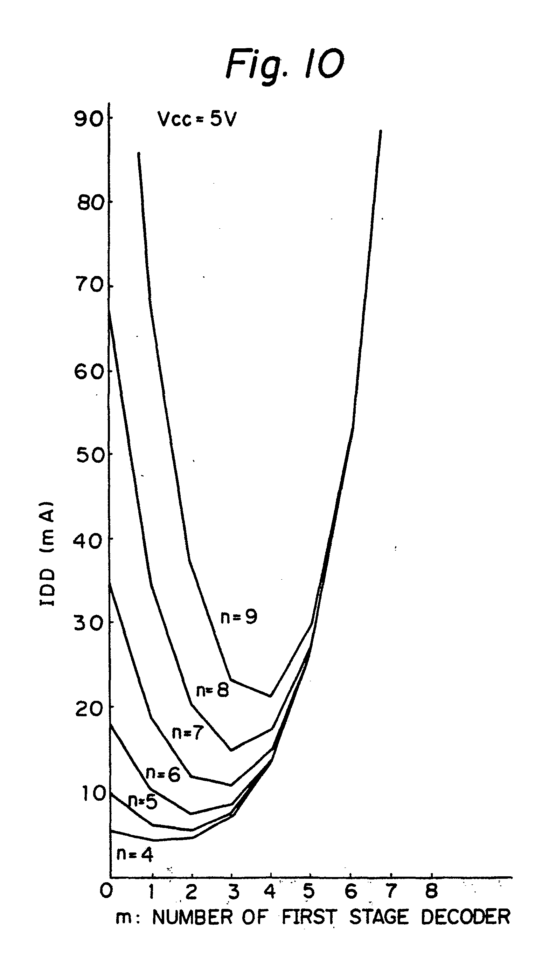

Figure 10 shows specific curves concerning the curve shown in Figure 4.

Before describing a preferred embodiment of the present invention, an explanation will be given of the prior art for reference.

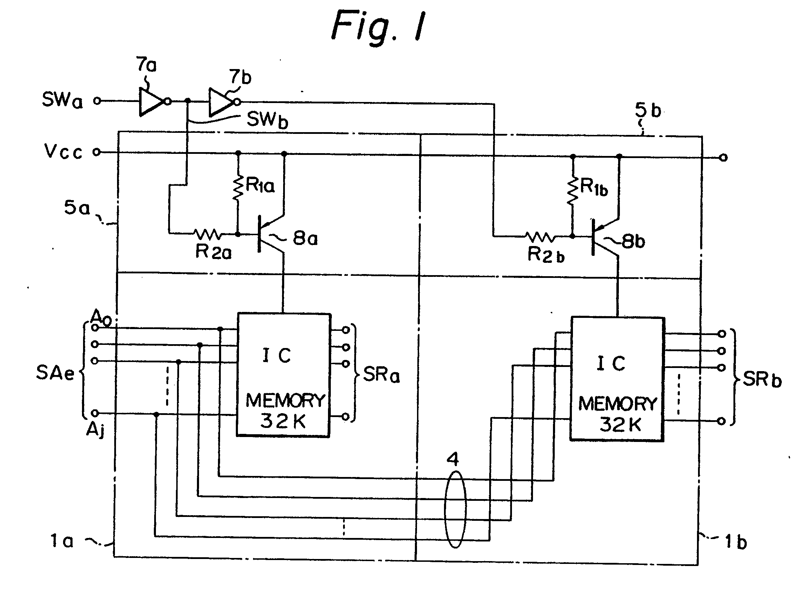

Figure 1 shows a prior art circuit of a memory system including two integrated semiconductor circuit (IC) memory devices provided in parallel. In Figure 1, the IC memory devices Ia,Ib have, for example, 32K bits capacities and are arranged in parallel through the line 4. This memory system therefore has a 64K bit capacity. When the input terminals at the IC memory devices Ia and/or Ib receive an external address signal SAe, consisting of $A_o$ through $A_j$ binary signals, the contents stored in the accessed memory cell is output as the read signal $SR_a$ and/or $SR_b$.

In order to reduce the power consumption, the memory devices Ia and Ib are externally provided with power switching circuits 5a and 5b. A switching signal $SW_a$ is applied to an inverter 7a, so as to generate a reversed signal $SW_b$, and is reversed again by an inverter 7b. The switching signals $SW_b$ and $SW_a$ are applied to the bases of power switching pnp transistors 8a and $8_b$ in the power switching circuits 5a and 5b through bias resistors R2a and R2b, respectively. The emitters of the transistors 8a and 8b are connected to a power line Vcc, and the collectors are connected to the memory devices Ia and Ib, respectively. Therefore, in this example, one of the memory devices is activated in response to the switching signal SWa or SWb.

Resistors Rla and Rlb are bias resistors.

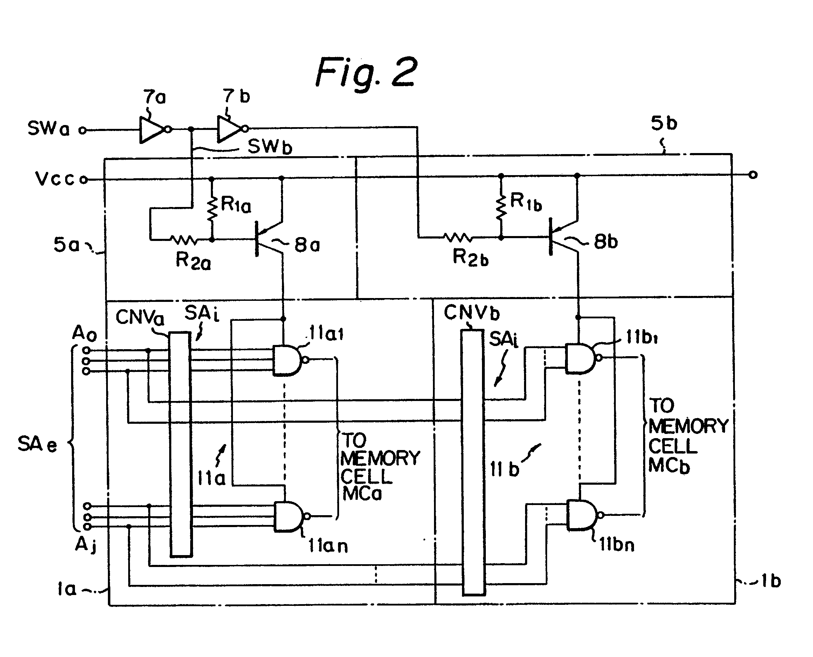

Figure 2 shows the connection of the power switching circuits 5a and 5b and decoder circuits IIa and IIb, represented as logic gates. The IC memory devices Ia and Ib include memory cells and control circuits. However, only address converter circuits $CNV_a$ and $CNV_b$ and decoder circuits IIa and IIb are shown in Fig. 2. The decoder circuit IIa consists of NAND gates $II_{al}$ through $II_{an}$ , while the decoder circuit IIb consists of NAND gates $II_{bl}$ through $II_{bn}$. Each of the NAND gates $II_{al}$ through $II_{an}$ and $II_{bl}$ through $II_{bn}$ receives an internal address signal SAi, converted from the external address signal SAe by the address converting circuits $CNV_a$ and $CNV_b$ , and outputs a word line activation signal corresponding to one of the memory cells of the memory cells MCa and MCb in the memory devices Ia and Ib.

Generally, the power consumption of the decoder circuit of a memory is approximately one-third to one-half of the total power consumption of the memory device.

In the prior art memory system comprising two-stage decoder circuits, i.e., a first stage consisting of the power switching circuits 5a and 5b externally installed to the memory devices la and lb and a second stage consisting of the decoder circuits 11a and llb in the memory devices la and lb, only one of the decoder circuits lla and llb operates at one time. This means the power consumption caused by the decoder circuits lla and llb is reduced by half. As mentioned earlier, however, there are disadvantages in that the power consumption cannot be reduced if the two memory devices are accessed at the same time; that the access time increases due to the operation time of the power switching transistors 8a and 8b and the requisite decoder circuit stabilizing time; and that the arrangement of the switching circuit externally to the memory device does not give sufficient power reduction for recent large memory devices.

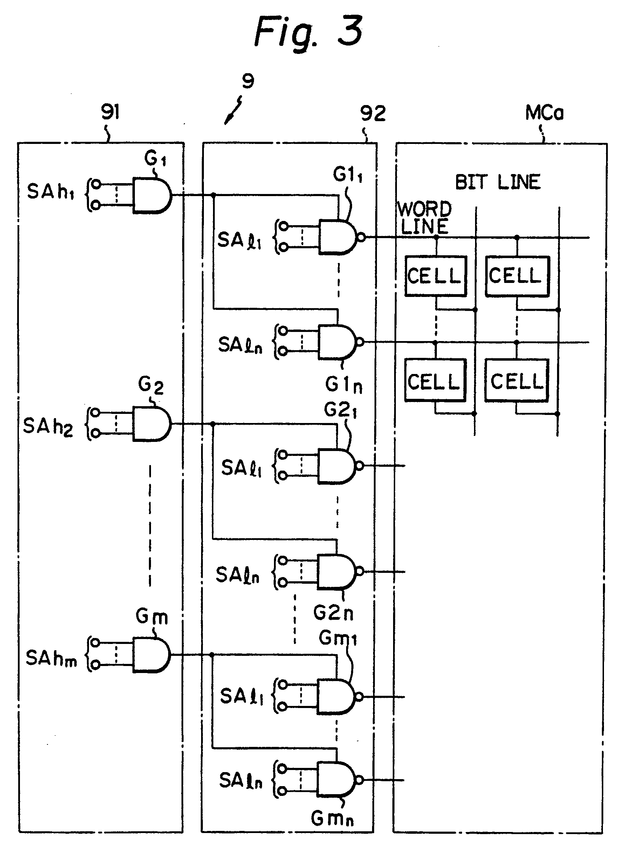

Figure 3 is a block diagram of a memory device, for example, an IC memory device which s the general arrangement of devices in accordance with the present invention and the prior art. In Fig. 3, the memory device includes a decoder circuit 9 consisting of a first-stage decoder 9l and a second-stage decoder 92, a plurality of semiconductor memory cells MCa storing information, a group of word lines connected to the second-stage decoder 92, and a group of bit lines connected to a multiplexer (not shown). The first-stage decoder 9l consists of a plurality of AND gates $G_l$ through $G_m$ (m is an integer). The second-stage decoder 92 consists of a plurality of NAND gate groups $Gl_l$ to $Gl_n$ , $G2_l$ to $G2_n$ , ---, $Gm_l$ to $Gm_n$ (n is an integer), each group being activated by one of the gates of the first-stage decoder 9l, as shown in Fig. 3.

Each set of a first-stage decoder gate and a corresponding group of second-stage decoder gates, for example, the gate $G_l$ and the gates $Gl_l$ to $Gl_n$ , defines a predetermined range of word lines.

In the decoder circuit 9 shown in Fig. 3, the gate $G_l$ corresponds to the power switching circuit 5a in Fig. 2 and the gates-$Gl_l$ to $Gl_n$ to the decoder circuit lla in Fig. 2. There are, however, substantial differences between the two constructions, i.e., a) first-stage decoder 9l is built into the memory device, b) the first-stage decoder 9l consists of a plurality of gates $G_l$ to $G_m$ , c) each of gates $G_l$ to $G_m$ activates a group of gates of the second-stage decoder 92 connected thereto, and d) only one set of a first-stage decoder gate and corresponding second-stage decoder can operate in response to an address signal upon an access command.

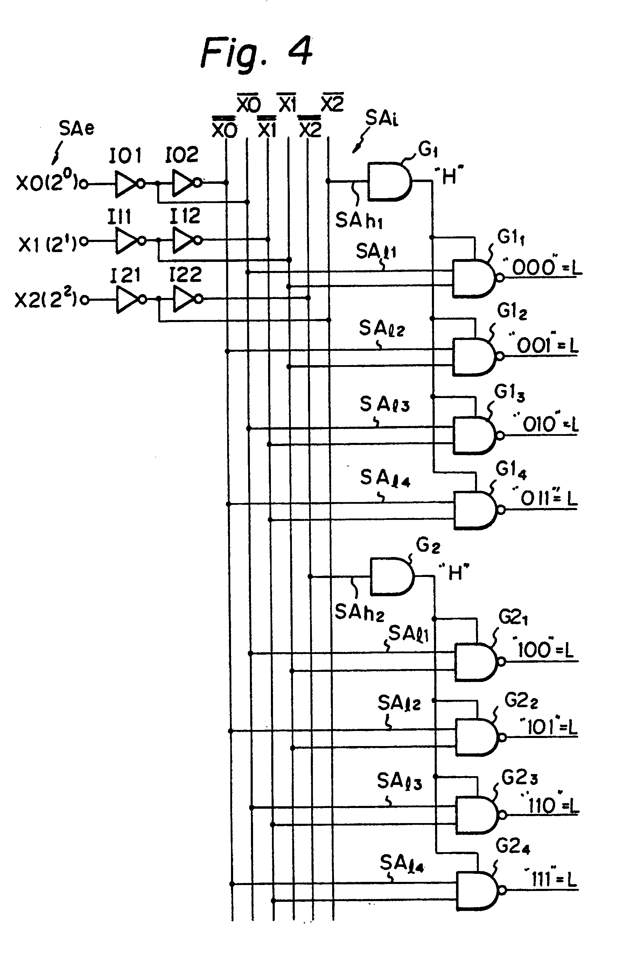

Figure 4 shows a circuit for converting from the external address signal SAe to the internal address signal SAi connected to the first- and second-stage decoder gates. In this example, the external address signal SAe consists of three binary bits, i.e., X0 representing $2^0$, Xl representing $2^l$, and X2 representing $2^2$. The range of the external address signal SAe is 0 to 7, as shown in Table I.

### Table 1

| | $SA_E$ | | |
| --- | --- | --- | --- |
| $SA_I$ | X2 | X1 | X0 |
| 0 | 0 | 0 | 0 |
| 1 | 0 | 0 | 1 |
| 2 | 0 | 1 | 0 |
| 3 | 0 | 1 | 1 |
| 4 | 1 | 0 | 0 |
| 5 | 1 | 0 | 1 |
| 6 | 1 | 1 | 0 |
| 7 | 1 | 1 | 1 |

In order to convert the external address signal SAe to the internal address signal SAi, two series inverters 101 and 102 are provided on the X0 bit line, 111 and 112 on the X1 bit line, and 121 and 122 on the X2 bit line. Thus, inverted signals $\overline{X0}$ to $\overline{X2}$ and reinverted (non-inverted signals) $\overline{\overline{X0}}$ to $\overline{\overline{X2}}$ are generated.

In this example, the first-stage decoder 91 has two (m = 2) gates, and the second-stage decoder 92 has eight ((n = 4) x 2) gates. Therefore, the internal address signal SAi, which can be generated by the combination of any inverted and reinverted signals, is connected to gates $G_1$ and $G_2$, which are "high (H)" level when they supply power to the corresponding decoder gates, and gates $G1_1$ to $G1_4$ and $G2_1$ to $G2_4$, which are "low (L)" level when one of them activates the corresponding word line.

As can be understood from the above in general, the higher bits $SA_{h1}$ to $SA_{hm}$ (or bit groups) of the internal address signal are connected to the first-stage decoder 91 so as to operate one of the gates $G_1$ to $G_m$. The lower bits (or bit groups) $SA_{\ell 1}$ to $SA_{\ell n}$ of the internal address signal are connected to the second-stage decoder 92. The internal address signal SAi is connected to each group of gates of the second-stage decoder 92 in the same way. Therefore, for example, the connections of the internal address signal SAi to gates $G1_1$, $G2_1$ ..., $Gm_n$ are the same.

In the embodiment shown in Figs. 3 and 4, only one set of a first-stage decoder gate and corresponding second-stage decoder gates, for example, the set of gate $G_1$ and gates $G1_1$ to $G1_n$, is operated upon an access command. The other sets are not operated. Therefore, only one set of gates consumes power in the decoder circuit 9. To obtain the minimum power consumption of the decoder circuit 9, the optimal division or distribution of the gates of the first-stage decoder 91 and the corresponding gates of the second-stage decoder 92 should be considered.

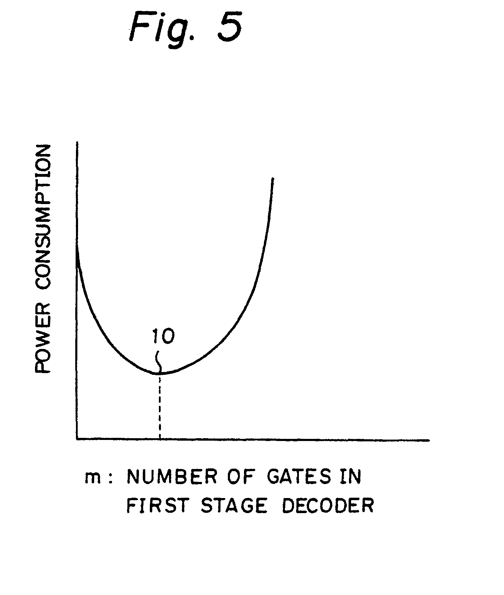

Figure 5 shows the relationship between the number of gates in the first-stage decoder 91 (horizontal axis) and the power consumption of decoder circuit 9 (vertical axis). The curve shows the minimum power consumption is achieved with 10 gates. This will be explained later in detail.

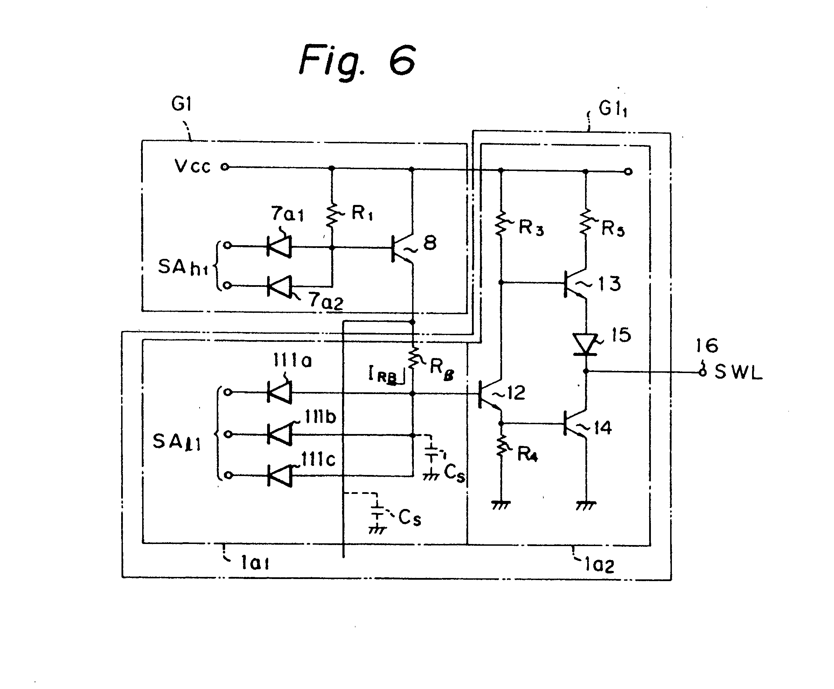

Figure 6 is detailed circuit diagram of an example of the first-stage decoder gate $G_1$ and the second-stage decoder gate $G1_1$ shown in Fig. 3. The gate $G_1$ includes a power switching transistor 8, a bias resistor R1, and diodes $7_{a1}$ and $7_{a2}$ connected in parallel. The collector of the transistor 8 is connected to the power line Vcc, and the base is connected to the connection point of anodes of the diodes $7_{a1}$ and $7_{a2}$ and the resistor R1. The emitter of the transistor 8 is connected to the corresponding gate $G1_1$.

In this embodiment, the gate $G1_1$ comprises an AND gate portion $1_{a1}$ and an inverter portion $1_{a2}$. The AND gate portion $1_{a1}$ includes diodes 111a to 111c connected in parallel and a bias resistor $R_B$. The inverter portion $1_{a2}$ includes transistors 12 to 14, resistors R3 to R5, and a diode 15. The base of the transistor 12 is connected to the connection point of the anodes of the diodes 111a to 111c and the resistor $R_B$; the collector is connected to the power line Vcc through the resistor R3; and the emitter is grounded through the resistor R4. The emitter of the transistor 12 is also connected the base of the transistor 14, and the collector is connected to the base of the transistor 13. The transistors 13 and 14 are connected in series through the diode 15. The collector of the transistor 13 is connected to the power line Vcc through the resistor R5, and the emitter is connected to the anode of the diode 15. The collector of the transistor 14 is connected to the cathode of the diode 15, and the emitter is grounded.

The word-line activation signal SWL is output at the terminal 16 connected to the collector of the transistor 14.

In this embodiment, the higher bits $SA_{h1}$ of the internal address signal, in this case two bits, are applied to the cathodes of the diodes 7a1 and 7a2, and the lower bits $SA_{\ell i}$ of the internal address signal, in this case three bits, are applied to the cathodes of the diodes 111a to 111c. The diodes 7a1 and 7a2 form an AND gate. The diodes 111a to 111c also form an AND gate.

Comparing the gate $G_1$ in Fig. 6 with the power switching circuit 5a in Fig. 1, the transistor 8 in the gate $G_1$ is an npn-type transistor instead of the pnp-transistor 8a. There is the distinctive merit that an npn-type transistor can be produced as a so-called "vertical" type transistor where an n-type epitaxial growth layer is formed on a p-type substrate. Therefore, an npn-type transistor has a high-frequency characteristic and a higher amplification factor compared with a pnp-type transistor, whereby the memory device formed by the npn-type transistor can provide a higher speed decoding operation and a better power switching operation than the prior memory system. Also the production process of an npn-type transistor is simpler than that of a pnp-type transistor.

The above-mentioned merits also apply to the npn-type transistors 12 to 14 in the gate $G1_1$ shown in Fig. 6.

The operation of the circuit shown in Fig. 6 will be described below. When all of the higher bits $SA_{h1}$ of the internal address signal applied to the cathodes of the diodes 7a1 and 7a2 in the gate $G_1$ are the high level ("H"), the npn transistor 8 is turned on. In addition, when all of the lower bits $SA_{\ell i}$ of the internal address signal applied to the cathodes of the diodes 111a to 111c provided in the AND gate portion $1a_1$ are the high level, the transistors 12 and 14 are turned on, whereby a low-level ("L") word line signal is output at the terminal 16.

When the transistor 8 is kept in the on state, however, one of the lower bits $SA_{\ell i}$ of the internal address signal applied to the diodes IIIa to IIIc is the low level, whereby almost all of the emitter current of the transistor 8 flows to one of the diodes IIIa to IIIc. The base of the first transistor I2 in the inverter portion $I_{a2}$ receives the bias voltage and the transistor I2 is turned on. However, a small emitter current of the transistor I2 flows to the ground through the resistor R4. Consequently, the third transistor I4 cannot be turned on, and the output signal SWL at the terminal I6 is the high level, which means non-selection of the word line.

When the transistor 8 in the gate $G_I$ is in the off state, the first and third transistors I2 and I4 are also off.

As can be understood from the above explanation, when the gate of the first-stage decoder is not in operation, the power consumption of the set of the first-stage decoder gate and the corresponding second-stage decoder gates is almost zero. Only one set of a first-stage decoder gate and corresponding second-stage decoder gates in the memory device is powered upon an access command. In addition, when one set is activated, only the first-stage decoder gate and one of the second-stage decoder gates are powered. The other second-stage decoder gates are not powered. This means a considerable reduction in the power consumption of the decoder circuit.

In the circuit in Fig. 6, use of Schottky barrier diodes for the diodes $7_{al}$ and $7_{a2}$ and the diodes IIIa to IIIc will reduce the operation time of the decoder circuit in accordance with the high-speed characteristics of Schottky diodes.

The above AND circuits consisting of the diodes $7_{al}$ and $7_{a2}$ and IIIa to IIIc can be replaced with an NAND circuit.

Now, in the circuit in Fig. 6, the higher bits of the internal address signal applied to the diodes $7_{al}$ and $7_{a2}$ in the first-stage decoder gate $G_I$ and the lower bits of the internal address signal applied to the diodes IIIa to IIIc of the AND portion $I_{al}$ in the second-stage decoder gate $GI_I$ , are split. Accordingly, a stray capacitance $C_S$ may be caused between the anodes of the diodes IIIa to IIIc and the ground, i.e., between the base and ground of the transistor I2, whereby too long a time may be taken after the transistor 8 turns off until the first transistor I2 in the inverter portion $I_{a2}$ turns off, due to the time constant of the capacitance $C_S$ and the resistor $R_B$. If the resistance of the resistor $R_B$ is large, the time for discharging the charge stored in the capacitance $C_S$ while the transistor 8 is turning on becomes too long.

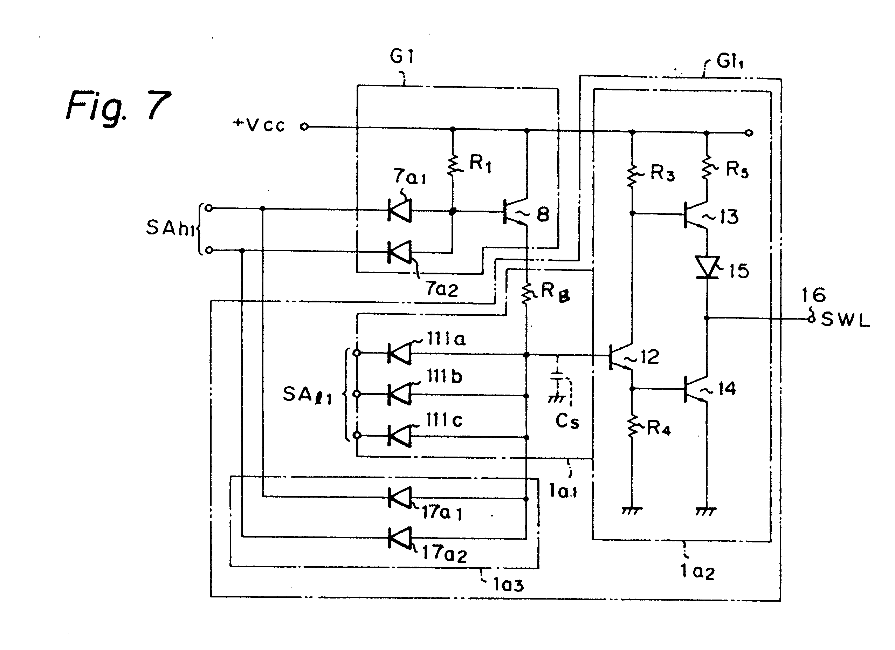

Figure 7 shows a first embodiment of the present invention in which this situation is improved. The circuit shown in Fig. 7 has an additional AND portion $I_{a3}$ consisting of diodes $I7_{al}$ and $I7_{a2}$ connected in parallel to make an AND gate. The cathodes of the diodes $I7_{al}$ and $17_{a2}$ receive the higher bits of the internal address signal similarly to the cathodes of the diodes $7_{al}$ and $7_{a2}$. The anodes are connected together and to the connection point of the anodes of the diodes IIIa to IIIc, resistor $R_B$ ` and the base of transistor I2.

In accordance with the circuit shown in Fig. 7, the charge stored in the stray capacitance $C_S$ formed between the base of the transistor I2 and the ground is discharged through the diodes $I7_{al}$ and $I7_{a2}$.

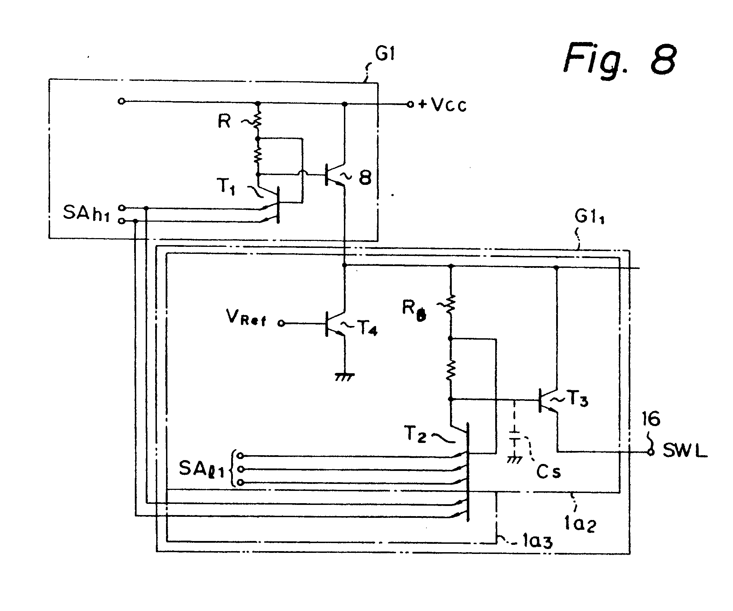

Figure 8 shows another embodiment of the decoder circuit. In this circuit, the operation time of the decoder circuit is improved by using the transistor-transistor -logic (TTL) technology. The first-stage decoder gate $G_I$ comprises a power switching transistor 8 similar to that of Figs. 6 and 7 and a multiemitter transistor $T_I$ instead of the diodes $7_{al}$ and $7_{a2}$. The higher bits of the internal address signal are applied to the emitters of the transistor $T_I$. The second-stage decoder gate $GI_I$ includes transistors $T_4$ and $T_3$ , a multiemitter transistor $T_2$ , and a resistor $R_B$. The higher and lower bits of the internal address signal are applied to the emitters of the transistor $T_2$ as similar to Fig. 7. The base of the transistor $T_4$ receives a reference voltage $V_{ref}$; the collector is connected to the emitter of transistor 8; and the emitter is grounded. The emitter of transistor 8 is also connected to the base of the transistor $T_3$ and the collector of the multiemitter transistor $T_2$ through the resistor $R_B$.

The basic principle of operation of this circuit is similar to that of the circuit shown in Fig. 7. Accordingly, the explanation of this circuit operation is omitted.

Determination of the number of gates of the first-stage and second-stage decoders for the minimum power consumption of the decoder circuit will be explained below with reference to the circuit shown in Fig. 3.

First, the number (m) of gates of the first-stage decoder 9I for minimizing the current of the second-stage decoder gates $GX_I$ to $GX_n$ (X is an arbitrary number of I to m) will be considered.

The overall decoder driver-circuit current IDD is defined as follows:

$$IDD = I_1 + I_3 \ (2^{n-m} - 1)I_4$$
$$+ \ (2^m - 1)I_2 + (2^n - 2^{n-m})I_5 \qquad \ldots (1)$$

where,

m: number of gates of the first-stage decoder,

n: number of gates of the second-stage decoder,

$I_l$: current flowing in the selected gate of first-stage decoder and not supplied to the gates of the second-stage decoder (only the current consumed by the gate of the first--stage decoder and not that supplied from the gate of the first-stage decoder to be gates of the second-stage decoder),

$I_2$: current flowing in the non-selected gates of the first-stage decoder,

$I_3$: current flowing in the selected gates of the second-stage decoder,

$I_4$: current flowing in the non-selected gates of the secondstage decoder connected to the selected gate of the first-stage decoder, and

$I_5$: current flowing in the non-selected gates of the first-stage decoder.

The currents $I_l$ to $I_5$ are determined by the resistance of the resistors in the circuit and do not depend on the numbers m and n.

Rewriting the notations $2^n$ and $2^m$ as N and M equation (I), one obtains:

$$IDD = I_1 + I_3 + (\frac{N}{M} - 1)I_4 + (M - 1)I_2$$
$$+ \ (N - \frac{N}{M})I_5$$

Rewriting the above equation, one obtains:

$$IDD = (I_4 - I_5)\frac{N}{M} + MI_2 + NI_5$$
$$+ \ (I_1 + I_3 - I_2 - I_4) \qquad \ldots (2)$$

The currents $I_l$ to $I_5$ and N are constant.

Differentiating equation (2) by m, one obtains:

$$\frac{dIDD}{dM} = -(I_4 - I_5)\frac{N}{M^2} + I_2 \qquad \ldots (3)$$

Further differentiating equation (3) by M, one obtains:

$$\frac{d^2IDD}{dM^2} = 2(I_4 - I_5)\frac{N}{M^3} \qquad \ldots (4)$$

As $I_4 \gg I_5$, the curve of IDD with a parameter M is basically an upward facing parabola. Accordingly, the minimum value of IDD is given by the following equation:

$$\frac{dIDD}{dM} = 0 \qquad \ldots (5)$$

From equations (3) and (5), the following equation is derived:

$$M^2 = (I_4 - I_5)\frac{N}{I_2}$$

Rewriting this to the original form, one obtains:

$$2^{2m} = \frac{I_4 - I_5}{I_2} 2^n$$

$$\therefore m = \frac{1}{2}(n + \log_2 \frac{I_4 - I_5}{I_2}) \qquad \dots \ (6)$$

The optimum number m of gates of the first-stage decoder can be obtained from equation (6). As the number m must be an integer, the optimum number of gates of the first-stage decoder is determined as the integer nearest to the value given by equation (6).

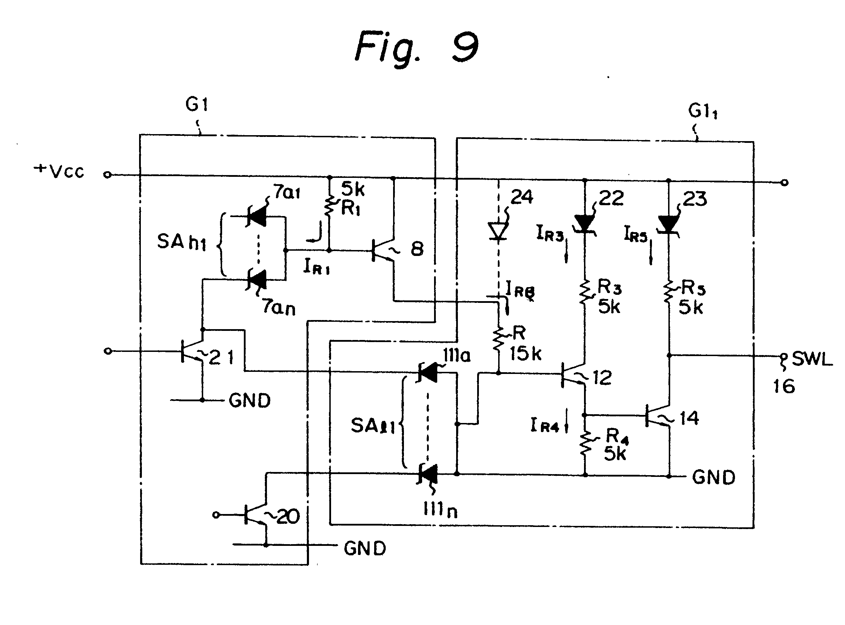

The current consumption of the decoder circuit under the optimum number m can be obtained by equation (I). The actual current of the circuit shown in Fig. 9, which is similar to that of Fig. 7, is calculated as an example. In Fig. 9, reference numerals 20 and 2I represent address inverter transistors for pulling the address signal of the first-stage and second-stage decoders into the ground. Reference numerals 22 and 23 are diodes connected between the resistors $R_3$ and $R_5$ and the power line Vcc.

In this example, the currents $IR_I$ , $IR_B$ , $IR_3$ , $IR_4$ , and $IR_5$ flowing through the resistors $R_I$ , $R_B$ , $R_3$ , $R_4$ , and $R_5$ are calculated, assuming the resistances $ÐR_I = R_3 = R_4 = R_5 = 5\ k\Omega$ and $R_B = 15\ k\Omega$.

The possible combinations of selection of the gates of the first-stage and second-stage decoders are shown in Table 2.

### Table 2

| Case | First-stage decoder gate | Second-stage decoder gate |
|------|-------------------------|---------------------------|
| 1    | Select                  | Select                    |
| 2    | Select                  | Nonselect                 |
| 3    | Nonselect               | Nonselect                 |

In case I of Table 2, the transistor 8 in Fig. 9 is turned on, whereby the current $I_{RB}$ flows through the resistors $R_B$. At this time, the transistors 20 and 21 are turned off and the transistor 12 in the gate $GI_I$ is turned on, whereby the current $I_{R3}$ flows through the resistor $R_3$. Also, the base of the transistor 14 receives the emitter current of the transistor I2, and the transistor I4 is turned on, whereby the current $I_{R5}$ flows through the resistor $R_5$. Table 3 represents the calculated currents $I_{RB}$ , $I_{R3}$ ` and $I_{R5}$ and the total current $I_3$ under a power (Vcc) of 4.5V, 5.0V, and 5.5V.

## Table 3

| I (mA) | Vcc (V) | | |
|---|---|---|---|
| | 4.5 | 5.0 | 5.5 |
| $I_{RB}$ | 0.14 | 0.17 | 0.21 |
| $I_{R3}$ | 0.58 | 0.68 | 0.78 |
| $I_{R5}$ | 0.74 | 0.84 | 0.94 |
| SUM $I_3$ | 1.46 | 1.69 | 1.93 |

Next, in case 2 of Table 2, the transistor 8 shown in Fig. 9 is turned on, the transistor 2l is turned off, and the transistor 20 is turned on. Accordingly, almost all of the current $I_{RB}$ flowing through the resistor $R_B$ flows into the ground through the diode llln, the collector of the transistor 20, and the emitter thereof. Also, the transistor 12 in gate Gl$_l$ is turned on, whereby the emitter current $I_{R4}$ of the transistor l2 flows into the ground through the resistor $R_4$. Table 4 represents the calculated currents $I_{RB}$ and $I_{R4}$ and the total current $I_4$ under a power (Vcc) of 4.5V, 5.0V, and 5.5V. In this case, the current $I_l$ is zero.

## Table 4

| I (mA) | Vcc (V) | | |
|---|---|---|---|
| | 4.5 | 5.0 | 5.5 |
| $I_{RB}$ | 0.19 | 0.22 | 0.25 |
| $I_{R4}$ | 0.04 | 0.04 | 0.04 |
| SUM $I_4$ | 0.23 | 0.26 | 0.29 |
| $I_1 = 0$ | | | |

Finally, in case 3 of Table 2, the transistors 8, l2, and l4 are turned off, however, the transistor 20 and 2l are tuned on. Accordingly, the current $I_{Rl}$ flowing through the resistor $R_l$, i.e., the current $I_2$, flows into the ground through diode $7_{an}$ and the collector and emitter of transistor 2l. Table 5 represents the current $I_{Rl}$ calculated under a power (Vcc) of 4.5V, 5.0V, 5.5V. The ,current $I_5$ is zero.

## Table 5

| I (mA) | Vcc (V) | | |
|---|---|---|---|
| | 4.5 | 5.0 | 5.5 |
| $I_2 = I_{R1}$ | 0.68 | 0.78 | 0.88 |
| $I_5 = 0$ | | | |

In order to obtain the opitimum number m of gates of the first-stage decoder for the number n of gates of the second-stage decoder, the currents $I_1$ to $I_5$ given in Table 3 to 5 are substituted into equation (5).

In order to obtain the minimum current consumption IDD of the decoder circuit, the optimum number m given by the above process is substituted into equation (I). Table 6 represents the current consumption IDD of the decoder circuit in accordance with the above condition.

## Table 6

| n | m | Vcc 4.5V IDD (mA) | Vcc 5.0V IDD | Vcc 5.5V IDD |
|---|---|---|---|---|
| 4 | 1 | 3.8 | 4.3 | 4.8 |
| 5 | 2 | 5.1 | 5.9 | 6.6 |
| 6 | 2 | 7.0 | 7.9 | 8.9 |
| 7 | 3 | 9.7 | 11.1 | 12.4 |
| 8 | 3 | 13.4 | 15.2 | 17.1 |
| 9 | 4 | 18.8 | 21.5 | 24.1 |
| 10 | 4 | 26.2 | 29.8 | 33.4 |

By way of reference in evaluating the present invention, the current consumption of a prior art decoder circuit is shown in Table 7. The current consumption of the prior art decoder circuit is calculated using a circuit similar to that shown in Fig. 9. The circuit is constructed as a single chip.

## Table 7

| No. of decoder gates | Vcc 4.5V (mA) | Vcc 5.0V (mA) | Vcc 5.5V (mA) |
|---|---|---|---|
| 4 | 4.9 | 5.6 | 6.3 |
| 5 | 8.6 | 9.8 | 10.9 |
| 6 | 16.0 | 18.1 | 20.2 |
| 7 | 30.7 | 34.7 | 38.8 |
| 8 | 60.1 | 68.0 | 75.9 |
| 9 | 119.0 | 134.6 | 150.1 |
| 10 | 236.8 | 267.7 | 298.6 |

Figure l0 shows current consumption (IDD) curves depending on the number (m) of gates of the first-stage decoder and the number (n) of gates of the second-stage decoder under a power (Vcc) of 5.0V. From the curves shown in Fig. l0, the optimum combination of m and n can be obtained.

As can be clearly understood from Tables 6 and 7, a decoder circuit of a two-stage construction as in the present invention can significantly reduce the power consumption of the decoder circuit compared with the prior art decoder circuit.

For example, when the decoder circuit in accordance with the present invention is used in a one-chip programmable read only memory device of 64K bits and there are three gates of the first-stage decoder and eight gates of the second-stage decoder, the current consumption is l5 mA. On the other hand, the prior art decoder circuit consumes 68 mA under the same conditions.

While the above embodiments were described with reference to the memory system shown in Figs. I and 2, the essence of the present invention is to form a two-stage decoder circuit. The external switching circuits shown in Figures 1 and 2 can also be applied to a memory system including a plurality of memory devices in accordance with the present invention.

In addition, a decoder circuit in accordance with the present invention may be constructed with three or more stages in consideration of the power consumption and the complexity of the circuit.

Thus the present invention provides a semiconductor memory device of considerably reduced power consumption and improved operation time. In addition, the manufacturing process of the semiconductor memory device including npn transistors becomes simple.

## Claims

1. A semiconductor memory device comprising a plurality of rows of memory cells (MCa); and decoder means for selecting one row of the matrix in response to a corresponding one of a plurality of address signals (SAi), the decoder means comprising a first stage decoder (9l) having a plurality of first stage decoding elements ($G_l$ ... $G_m$)' each of the first stage decoding elements being connected to a plurality of second stage decoding elements ($Gl_l$ ... $Gm_n$) of a second stage decoder (92), wherein each of the first stage decoding elements ($G_l$ $G_m$) receives part of the plurality of address signals ($SAh_l$), whereby one of the second stage decoding elements causes a row of the matrix to be selected, and wherein each of the second stage decoding elements ($Gl_l$... $Gm_n$) includes at least one second gate circuit ($la_l$) receiving said remaining part of the plurality of address signals ($SA_{ll}$), the output of the second gate circuit being connected to the output of the respective first stage decoding element ($G_l$ ... $G_m$), and at least one switching element (I2) having a trigger terminal connected to the output of the respective first stage decoding element ($G_l$ ... $G_m$), the output of the switching element (I2) selecting one of the rows of memory cells when the output of the corresponding first stage decoding element ($G_l$ ... $G_m$) is high and the output of the second gate circuit ($la_l$) is high, characterised in that the second gate circuit ($la_l$) comprises a plurality of diodes (IIIa - IIIc) arranged to form an AND gate and in that each second gate circuit ($la_l$) includes an extra gate portion ($la_3$) comprising a number of diodes ($17a_l$, $17a_2$) arranged to form an AND gate and for receiving the part of the address signals($SA_{hl}$) fed to the corresponding first stage decoding elements ($G_l$ ... $G_m$).

2. A semiconductor device according to claim I, wherein each of the first stage decoding elements ($G_l$ $Gm$) includes a first gate circuit comprising a number of diodes ($7a_l$, $7a_2$) arranged to form an AND gate for receiving said first part of the address signal ($SA_{hl}$), and at least one first switching element (8), the first switching element (8) being turned on when an output of the first gate circuit is high to supply power to the corresponding second stage decoding elements ($G_l$ ... $G_{m)}$ .

3. A semiconductor device according to claim 2, in which the diodes ($7al$, $7a2$) are Schottky barrier diodes.

4. A semiconductor memory device comprising a plurality of rows of memory cells (MCa); and decoder means for selecting one row of the matrix in response to a corresponding one of a plurality of address signals (SAi), the decoder means comprising a first stage decoder (9l) having a plurality of first stage decoding elements ($G_l$ ... Gm) each of the first stage decoding elements being connected to a plurality of second stage decoding elements ($G_l$ ... Gm) of a second stage decoder (92), wherein each of the first stage decoding elements ($G_l$ ... $G_m$) receives part of the plurality of address signals ($SAh_l$), whereby one of the second stage decoding elements causes a row of the matrix to be selected, and wherein each of the second stage decoding elements ($Gl_l$ ... $Gm_n$) includes at least one second gate circuit ($la_2$) receiving said remaining part of the plurality of address signals ($SA_{ll}$), the output of the second gate circuit being connected to the output cf the respective first stage decoding element ($G_l$ ... Gm), and at least one switching element ($T_3$) having a trigger terminal connected to the output of the respective first stage decoding element ($G_1$ ... Gm), the output of the switching element ($T_3$) selecting one of the rows of memory cells when the output of the corresponding first stage decoding element ($G_1$ ... Gm) is high and the output of the second gate circuit is high characterised in that the second gate circuit ($1a_2$) comprises a multi-emitter transistor ($T_2$) forming an AND gate and to respective emitters of which are fed said remaining part of the plurality of address signals ($SA_{ll}$) and the part of the address signals ($SAh_l$) fed to the corresponding first stage decoding elements ($G_l$ ... $G_m$)

5. A semiconductor device according to claim 2, wherein each of the first stage decoding elements ($G_l$ ... $G_m$ ) includes a multi-emitter transistor ($T_l$) forming an AND gate and for receiving said first part of the address signal ($SAh_l$) at the emitters, and a first switching element (8), the first switching element (8) being turned on when a collector potential of the multi-emitter transistor ($T_l$) is high to supply power to the corresponding second stage decoding elements ($Gl_l$ ... $Gm_n$).

6. A semiconductor memory device according to claim 3, wherein the or each first switching element (8) comprises an npn transistor.

**Revendications**

1. I. Dispositif de mémoire à semi-conducteur comportant plusieurs rangées de cellules de mémoire (MCa) et un dispositif décodeur pour sélectionner une rangée de la matrice en réponse à l 'un correspondant de plusieurs signaux d'adresse (SAi ), le dispositif décodeur comportant un décodeur de premier étage (9l) comprenant plusieurs éléments de décodage de premier étage ($G_l$ .. . $G_m$) , chacun des éléments de décodage de premier étage étant connecté à plusieurs éléments de décodage de second étage ($Gl_l'$ .$Gm_n$) d'un décodeur de second étage (92) , dans lequel chacun des éléments de décodage de premier étage ($G_l$ . . .$G_m$) reçoit une partie des plusieurs signaux d'adresse ($SAh_l$), de manière que l 'un des éléments de décodage de second étage entraîne qu'une rangée de la matrice soit sélectionnée et dans lequel chacun des éléments de décodage de second étage ($Gl_l$ ...$Gm_n$)

EP 0 115 187 B1

comporte au moins un second circuit de porte (Ia$_l$) qui reçoit la partie qui reste des plusieurs signaux d'adresse (SA$_{II}$), la sortie du second circuit de porte étant connectée à la sortie de l 'élément respectif de décodage de premier étage (G$_l$ . . .G$_m$) et au moins un élément de commutation (I2) ayant une borne de déclenchement connectée à la sortie de l 'élément respectif de décodage de premier étage (G$_l$ .. .G$_m$), la sortie de l 'élément de commutation (I2) sélectionnant l 'une des rangées de cellules de mémoire quand la sortie de 1 'élément correspondant de décodage de premier étage (G$_l$. . .G$_m$) est au niveau haut et que la sortie du second circuit de porte (Ia$_l$) est au niveau haut, caractérisé en ce que le second circuit de porte (Ia$_l$) comporte plusieurs diodes (IIIa-IIIc) disposées pour former une porte ET et en ce que chaque second circuit de porte (Ia$_l$) comporte une partie de porte supplémentaire (Ia$_3$) comprenant un certain nombre de diodes (I7a$_l$, I7a$_2$) disposées pour former une porte ET et pour recevoir la partie des signaux d'adresse (SA$_{hl}$ ) fournis aux éléments correspondants de décodage de premier étage (G$_l$...G$_m$).

2. Dispositif à semi-conducteur selon la revendication I, dans lequel chacun des éléments de décodage de premier étage (G$_l$. . .Gm) comporte un premier circuit de porte comprenant un certain nombre de diodes (7a$_l$, 7a$_2$) disposées pour former une porte ET qui reçoit ladite première partie du signal d'adresse (SA$_{hl}$ ) et au moins un premier élément de commutation (8), le premier élément de commutation (8) étant débloquè lorsque la sortie du premier circuit de porte est au niveau haut pour fournir une alimentation aux éléments correspondants de décodage de second étage (G$_l$ . . .G$_m$).

3. Dispositif à semi-conducteur selon la revendication 2, dans lequel les diodes (7al , 7a2) sont des diodes à barrière de Schottky.

4. Dispositif de mémoire à semi-conducteur comportant plusieurs rangées de cellules de mémoire (MCa) et un dispositif décodeur destiné à sélectionner une rangée de la matrice en réponse à l 'un correspondant de plusieurs signaux d'adresse (SAi ) , le dispositif décodeur comprenant un décodeur de premier étage (9I) ayant plusieurs éléments de décodage de premier étage (G$_l$ . . .G$_m$)' chacun des éléments de décodage de premier étage étant connecté à plusieurs éléments de décodage de second étage (G$_l$. . .G$_m$) d'un décodeur de second étage (92), dans lequel chacun des éléments de décodage de premier étage (G$_l$ . . .G$_m$) reçoit une partie de plusieurs signaux d'adresse (SAh$_l$) de manière que l 'un des éléments de décodage de second étage entraîne qu'une rangée de la matrice soit sélectionnèe et dans lequel chacun des éléments de décodage de second étage (Gl$_l$ . . .Gm$_n$) comporte au moins un second circuit de porte (Ia$_2$) recevant la partie qui reste des plusieurs signaux d'adresse (SA$_{II}$), la sortie du second circuit de porte étant connectée à la sortie de l 'élément respectif de dècodage de premier étage (G$_l$. . .G$_m$) et au moins un élément de commutation (T$_3$) ayant une borne de déclenchement connectée à la sortie de l 'élément respectif de décodage de premier étage (G$_l$... G$_m$), la sortie de l'élément de commutation sélectionnant l 'une des rangées de cellules de mémoire quand la sortie de l'élément correspondant de décodeur de premier étage (G$_l$ . . .G$_m$) est au niveau haut et que la sortie du second circuit de porte est au niveau haut, caractérisé en ce que le second circuit de porte (Ia$_2$) comporte un transistor à émetteurs multiples (T$_2$) formant une porte ET et dont les émetteurs respectifs reçoivent ladite partie qui reste des plusieurs signaux d'adresse (SA$_{II}$) et la partie des signaux d'adresse (SAh$_l$) fournis aux éléments correspondants de décodage de premier étage (G$_l$. . .G$_m$)

5. Dispositif de mémoire à semi-conducteur selon la revendication 2, dans lequel chacun des éléments de décodage de premier étage (G$_l$. . .Gm) comporte un transistor à émetteurs multiples (T$_l$) formant une porte ET et qui reçoit ladite première partie du signal d'adresse (SAh$_l$ ) aux émetteurs et un premier élément de commutation (8), le premier élément de commutation (8) étant débloqué lorsque le potentiel de collecteur du transistor à émetteurs multiples (T$_l$) est au niveau haut pour fournir une alimentation aux éléments correspondants de décodage de second étage (Gl$_l$. . .Gm$_n$).

6. Dispositif de mémoire à semi-conducteur selon la revendication 3, dans lequel le ou chaque premier élément de commutation (8) consiste en un transistor NPN.

**Ansprüche**

1. Halbleiterspeichervorrichtung mit einer Vielzahl von Reihen von Speicherzellen (MCa); und Decodereinrichtungen zum Auswählen einer Reihe der Matrix, ansprechend auf ein entsprechendes einer Vielzahl

13

von Adreßsignalen (SAi), welche Decodereinrichtung einen ersten Stufendecoder (9l) umfaßt, der eine Vielzahl von Erststufendecoderelementen ($G_l$ ... $G_m$) hat, wobei jedes der Erstufendecoderelemente mit einer Vielzahl von Zweitstufendecoderelementen ($Gl_l$ ... $Gm_n$) eines Zweitstufendecoders (92) verbunden ist, wobei jedes der Erstufendecoderelemente ($G_l$ ... $G_m$) einen Teil einer Vielzahl von Adreßsignalen ($SAh_l$) empfängt, wodurch eines der Zweitstufendecoderelemente bewirkt, daß eine Reihe der Matrix ausgewählt wird, und wobei jedes Zweitstufendecoderelement ($Gl_l$ ... $Gm_n$) wenigstens eine zweite Torschaltung ($la_l$) umfaßt, welche den genannten verbleibenden Teil von der Vielzahl von Adreßsignalen ($SA_{ll}$) empfängt, der Ausgang der zweiten Torschaltung mit dem Ausgang des entsprechenden Erststufendecoderelementes ($G_l$ ... $G_m$) verbunden ist und wenigstens ein Schaltelement (l2) einen Triggeranschluß hat, der mit dem Ausgang des entsprechenden Erststufendecoderelementes ($G_l$ ... Gm) verbunden ist, und der Ausgang des Schaltelementes (l2) eine der Reihen der Speicherzellen auswählt, wenn der Ausgang des entsprechenden Erststufendecoderelementes ($G_l$ ... $G_m$) hoch ist und der Ausgang der zweiten Torschaltung ($la_l$) hoch ist, dadurch gekennzeichnet, daß die zweite Torschaltung ($la_l$) eine Vielzahl von Dioden (IIla - IIIc) umfaßt, die angeordnet sind, um ein UND-Tor zu bilden, und daß jede zweite Torschaltung ($la_l$) einen extra Torabschnitt ($la_3$) enthält, der eine Zahl von Dioden ($l7a_l$, $l7a_2$) umfaßt, die angeordnet sind, um ein UND-Tor zu bilden und um den Teil der Adreßsignale ($SAh_l$) zu empfangen, der den entsprechenden Erststufendecoderelementen ($G_l$ ... Gm) zugeführt wird.

2. Halbleitervorrichtung nach Anspruch I, bei der jedes der Erststufendecoderelemente ($G_l$ ... $G_m$) eine erste Torschaltung enthält, die eine Zahl von Dioden ($7a_l$, $7a_2$) umfaßt, die angeordnet sind, um ein UND-Tor zu bilden, um den genannten ersten Teil des Adreßsignals ($SA_{hl}$) zu empfangen, und wenigstens ein erstes Schaltelement (8), wobei das erste Schaltelement (8) eingeschaltet wird, wenn ein Ausgang der ersten Torschaltung hoch ist, um Energie an die entsprechenden Zweitstufendecoderelement ($G_l$ ... $G_m$ zu liefern.

3. Halbleitervorrichtung nach Anspruch 2, bei der die Dioden (7al, 7a2) Schottky-Grenzdioden sind.

4. Halbleiterspeichervorrichtung mit einer Vielzahl von Reihen von Speicherzellen (MCa); und Decodereinrichtungen zum Auswählen einer Reihe der Matrix, ansprechend auf ein entsprechendes einer Vielzahl von Adreßsignalen (SAi), welche Decodereinrichtung einen Erststufendecoder (9l) umfaßt, der eine Vielzahl von Erststufendecoderelementen ($G_l$ ... $G_m$) hat, wobei jedes der Erststufendecoderelemente mit einer Vielzahl von Zweitstufendecoderelementen ($G_l$ ... $G_m$) eines Zweitstufendecoders (92) verbunden ist, wobei jedes der Erststufendecoderelemente ($G_l$ ... $G_m$) einen Teil einer Vielzahl von Adreßsignalen ($SAh_l$) empfängt, wodurch eines der Zweitstufendecoderelemente bewirkt, daß eine Reihe der Matrix ausgewählt wird, und wobei jedes Zweitstufendecoderelement ($Gl_l$ ... $Gm_n$) wenigstens eine zweite Torschaltung ($la_2$) enthält, die den verbleibenden Teil der Vielzahl von Adreßsignalen ($SA_{ll}$) empfängt, der Ausgang der zweiten Torschaltung mit dem Ausgang des entsprechenden Erststufendecoderelementes ($G_l$ ... $G_m$) verbunden ist, und wenigstens ein Schaltinstrument ($T_3$) einen Triggeranschluß hat, der mit dem Ausgang des entsprechenden Erststufendecoderelementes ($G_l$ ... $G_m$) verbunden ist, der Ausgang des Schaltelements ($T_3$) eine der Reihen der Speicherzellen auswählt, wenn der Ausgang des entsprechenden Erststufendecoderelementes ($G_l$ ... $G_m$) hoch ist und der Ausgang der zweiten Torschaltung hoch ist, dadurch gekennzeichnet, daß die zweite Torschaltung ($la_2$) einen Multiemittertransistor ($T_2$) umfaßt, der ein UND-Tor bildet und dessen entsprechenden Emittern der genannte verbleibende Teil der Vielzahl von Adreßsignalen ($SA_{ll}$) und der Teil des Adreßsignals ($SAh_l$)- zugeführt wird, der den entsprechenden Erststufendecoderelementen ($G_l$ ... $G_m$) zugeführt wird.

5. Halbleiterspeichervorrichtung nach Anspruch 2, bei der jedes der Erststufendecoderelemente ($G_l$ ... Gm) einen Multiemittertransistor ($T_l$) umfaßt, der ein UND-Tor bildet und zum Empfangen des genannten ersten Teils des Adreßsignals ($SAh_l$) an den Emittern, und ein erstes Schaltelement (8), welches erste Schaltelement (8) eingeschaltet wird, wenn das Kollektorpotential des Multiemittertransistors ($T_l$)-hoch ist, um Energie an die entsprechenden Zweitstufendecoderelemente ($Gl_l$ ... $Gm_n$) zu liefern.

6. Halbleiterspeichervorrichtung nach Anspruch 3, bei der das oder jedes erste Schaltelement (8) einen npn-Transistor umfaßt.

Fig. 1

# Fig. 2

EP 0 115 187 B1

# Fig. 3

Fig. 4

# Fig. 5

POWER CONSUMPTION

10

m : NUMBER OF GATES IN
FIRST STAGE DECODER

Fig. 6

EP 0 115 187 B1

Fig. 7

EP 0 115 187 B1

Fig. 8

EP 0 115 187 B1

Fig. 9

# Fig. 10